# EUROPEAN PATENT APPLICATION

(11) **EP 1 770 768 A2**
(43) Date of publication of application: **04.04.2007**
(21) Application number: 06121519.0
(22) Date of filing: 29.09.2006
(51) Int. Cl.: H01L 21/321, C09G 1/02

(54) **Polishing method, polishing composition and polishing composition kit**

(30) Priority: 30.09.2005 JP 2005289170
(71) Applicant: FUJIMI INCORPORATED, Kiyosu-shi, Aichi 452-8502 (JP)
(72) Inventor: Shimizu, Mikikazu c/o Fujimi Incorporated, Kiyosu-shi, Aichi 452-8502 (JP)
(74) Representative: Viering, Jentschura & Partner

(57) **Abstract**

A polishing method for polishing a polysilicon film provided on a silicon substrate having an isolation region is provided. The method includes preliminarily polishing the polysilicon film using a preliminary polishing composition containing abrasive grains, an alkali, a water-soluble polymer, and water till a part of the top surface of the isolation region is exposed; and finally polishing the preliminarily polished polysilicon film using a final polishing composition containing abrasive grains, an alkali, a water-soluble polymer, and water till the whole top surface of the isolation region is exposed. The content of the water-soluble polymer in the preliminary polishing composition is 0.0075-0.05 % by mass, and the content of the water-soluble polymer in the final polishing composition is 0.002-0.01 % by mass.

## Description

### BACKGROUND OF THE INVENTION

The present invention relates to a polishing method for polishing a polysilicon film provided on a silicon substrate and to a polishing composition and a polishing composition kit used in the polishing method.

When a polysilicon film provided on a silicon substrate is polished using a polishing composition in order to form a device area on the silicon substrate, it is desirable that dishing should occur as little as possible. Dishing refers to a phenomenon that a part of the polysilicon film which should not be removed is polished and removed thereby causing dishes on the polished surface and dishing causes deterioration of flatness.

A polishing composition improved for suppressing development of dishing is disclosed in Japanese Laid-Open Patent Publication No. 2004-266155. The polishing composition of Japanese Laid-Open Patent Publication No. 2004-266155 comprises abrasive grains, alkali, water-soluble polymer, and water. However, the polishing composition of Japanese Laid-Open Patent Publication No. 2004-266155 does not satisfy the required performance with regard to dishing enough and has still room to be improved.

### SUMMARY OF THE INVENTION

Accordingly, an objective of the present invention is to provide a polishing method which enables preferable polishing of a polysilicon film provided on a silicon substrate and a polishing composition and a polishing composition kit used in the polishing method.

As a result of intensive study for achieving the objective mentioned above, the present inventor has found that the range of content of a water-soluble polymer in the polishing composition suitable for suppressing dishing is different between polishing before a part of the top surface of an isolation region is exposed and polishing after a part of the top surface of an isolation region is exposed and before the whole top surface thereof is exposed and thus completed the present invention.

In accordance with a first aspect of the present invention, a polishing method for polishing a polysilicon film provided on a silicon substrate having an isolation region is provided. The method includes preliminarily polishing the polysilicon film using a preliminary polishing composition containing abrasive grains, an alkali, a water-soluble polymer, and water till a part of the top surface of the isolation region is exposed; and finally polishing the preliminarily polished polysilicon film using a final polishing composition containing abrasive grains, an alkali, a water-soluble polymer, and water till the whole top surface of the isolation region is exposed. The content of the water-soluble polymer in the preliminary polishing composition is 0.0075-0.05 % by mass, and the content of the water-soluble polymer in the final polishing composition is 0.002-0.01 % by mass.

In accordance with a second aspect of the present invention, a polishing composition used for polishing a polysilicon film provided on a silicon substrate having an isolation region is provided. The polishing composition includes abrasive grains, an alkali, a water-soluble polymer, and water. The content of the water-soluble polymer in the polishing composition is 0.0075-0.05 % by mass.

In accordance with a third aspect of the present invention, a polishing composition used for polishing a polysilicon film provided on a silicon substrate having an isolation region is provided. The polishing composition includes abrasive grains, an alkali, a water-soluble polymer, and water. The content of the water-soluble polymer in the polishing composition is 0.002-0.01 % by mass.

In accordance with a fourth aspect of the present invention, a kit for use in polishing a polysilicon film provided on a silicon substrate having an isolation region is provided. The kit includes a preliminary polishing composition used in preliminarily polishing the polysilicon film till a part of the top surface of the isolation region is exposed; and a final polishing composition used in finally polishing the preliminarily polished polysilicon film till the whole top surface of the isolation region is exposed. The preliminary polishing composition contains abrasive grains, an alkali, a water-soluble polymer, and water. The content of the water-soluble polymer in the preliminary polishing composition is 0.0075-0.05 % by mass. The final polishing composition contains abrasive grains, an alkali, a water-soluble polymer, and water. The content of the water-soluble polymer of the final polishing composition is 0.002-0.01 % by mass.

In accordance with a fifth aspect of the present invention, a kit for use in polishing a polysilicon film provided on a silicon substrate having an isolation region is provided. The kit includes a preliminary polishing composition and an adjuvant. The preliminary polishing composition contains abrasive grains, an alkali, a water-soluble polymer, and water. The content of the water-soluble polymer in the preliminary polishing composition is 0.0075-0.05 % by mass. The adjuvant contains at least one ingredient of abrasive grains, an alkali, a water-soluble polymer, and water. The adjuvant is mixed with the preliminary polishing composition to prepare a final polishing composition.

In accordance with a sixth aspect of the present invention, a kit for use in polishing a polysilicon film provided on a silicon substrate having an isolation region is provided. The kit includes a final polishing composition and an adjuvant. The final polishing composition contains abrasive grains, an alkali, a water-soluble polymer, and water. The content of the water-soluble polymer in the final polishing composition is 0.002-0.01 % by mass. The adjuvant contains at least one ingredient of abrasive grains, an alkali, a water-soluble polymer, and water. The adjuvant is mixed with the final polishing composition to prepare a preliminary polishing composition.

Other aspects and advantages of the invention will become apparent from the following description, illustrating by way of example the principles of the invention.

### BRIEF DESCRIPTION OF THE DRAWINGS

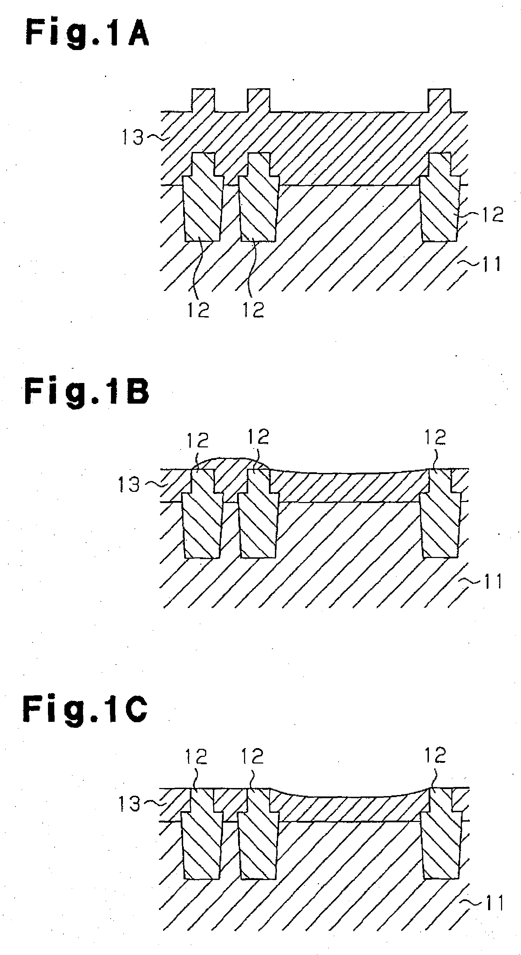

Figs. 1A, 1B and 1C are cross-sectional views of an object to be polished for explaining the method of forming a device area.

### DETAILED DESCRIPTION OF THE PREFERRED EMBODIMENTS

Hereinbelow, an embodiment of the present invention is described referring to Figs. 1A, 1B and 1C.

A device area is formed on a silicon substrate 11 as fallows in the present embodiment. First, a polysilicon film 13 is formed on the silicon substrate 11 in which isolation regions 12 made of silicon oxide are embedded as shown in Fig. 1A. Then, the polysilicon film 13 is polished till the top surface of each isolation region 12 is exposed. In other words, at least part of the polysilicon film 13 (outer portion of the polysilicon film 13) which does not overlap the isolation regions 12 in the direction perpendicular to the thickness of the silicon substrate 11 is removed by polishing. As a result, at least one part of the polysilicon film 13 (inner portion of the polysilicon film 13) which overlaps the isolation regions 12 in the direction perpendicular to the thickness of the silicon substrate 11 remains on the silicon substrate 11 as shown in Fig. 1C. A part of the polysilicon film 13 left on the silicon substrate 11 will function in this way as the device area.

When at least the outer portion of the polysilicon film 13 is removed by polishing, preliminarily polishing which removes at least most of the outer portion of the polysilicon film 13 is performed at first as shown in Fig. 1B. This step is finished at a time point when a part of the top surface of the isolation regions 12 becomes exposed. Then, finally polishing which removes at least the residue of the outer portion of the polysilicon film 13 is performed in order to expose the whole top surface of each isolation region 12 as shown in Fig. 1C.

A preliminary polishing composition is used in the first polishing which removes at least most of the outer portion of the polysilicon film 13 and another final polishing composition is used in the subsequent polishing which removes at least the residue of the outer portion of the polysilicon film 13. A kit of the present embodiment comprises these compositions for preliminarily polishing and finally polishing, and it is used in an application for polishing the polysilicon film 13 provided on the silicon substrate 11 in order to form the device area on the silicon substrate 11. Hereinbelow, the preliminary polishing composition and the final polishing composition are described in this order.

### Preliminary polishing composition

The preliminary polishing composition is produced by mixing abrasive grains, alkali, water-soluble polymer, and water. Accordingly, the preliminary polishing composition substantially consists of abrasive grains, alkali, water-soluble polymer, and water.

Abrasive grains in the preliminary polishing composition play a role of mechanically polishing the polysilicon film 13 and contribute to improving the polishing rate (removal rate) for the polysilicon film 13 made by the preliminary polishing composition. Abrasive grains contained in the preliminary polishing composition may be either silica such as fumed silica and colloidal silica, or abrasive grains other than silica, but preferably they are fumed silica or colloidal silica, and particularly preferably they are colloidal silica. When the abrasive grains contained in the preliminary polishing composition are fumed silica or colloidal silica, a good polished surface is readily obtained when the preliminary polishing composition is used to polish the polysilicon film 13. When abrasive grains contained in the preliminary polishing composition are colloidal silica, a good polished surface is readily obtained and in addition, the polishing rate for the polysilicon film 13 made by the preliminary polishing composition is significantly improved.

When the average particle size of abrasive grains calculated from BET specific surface area of abrasive grains contained in the preliminary polishing composition is less than 20 nm, or even when it is less than 25 nm, the rate of polishing the polysilicon film 13 by the preliminary polishing composition is not significantly improved. When the polishing rate for the polysilicon film 13 made by the preliminary polishing composition is not high enough, scratches resulting on the polished surface may increase when the polysilicon film 13 is polished with the preliminary polishing composition. Therefore, it is preferable for the improvement of polishing rate for the polysilicon film 13 by the preliminary polishing composition that the average particle size of abrasive grains contained in the preliminary polishing composition is greater than or equal to 20 nm, and more preferably it is greater than or equal to 25 nm. On the other hand, when the average particle size of abrasive grains calculated from BET specific surface area of abrasive grains contained in the preliminary polishing composition is greater than 100 nm, or even when it is greater than 75 nm, surface roughness of the polished surface may increase when the polysilicon film 13 is polished with the preliminary polishing composition. In addition, abrasive grains may be more likely to aggregate and thus deposit. Therefore, it is preferable that the average particle size of abrasive grains contained in the preliminary polishing composition is less than 100 nm, and more preferably it is less than 75 nm in order to suppress increase in the roughness of the polished surface and suppress aggregation of abrasive grains.

When the content of abrasive grains in the preliminary polishing composition is less than 0.5 % by mass, or even when it is less than 1 % by mass, the polishing rate for the polysilicon film 13 by the preliminary polishing composition is not significantly improved. Therefore, it is preferable that the average particle size of abrasive grains contained in the preliminary polishing composition is greater than or equal to 0.5 % by mass, and more preferably it is greater than or equal to 1 % by mass. On the other hand, when the content of abrasive grains in the preliminary polishing composition is more than 20 % by mass, or even when it is more than 10 % by mass, gelation of the preliminary polishing composition and aggregation of abrasive grains may occur. Therefore, it is preferable that the content of abrasive grains in the preliminary polishing composition is less than or equal to 20 % by mass, and more preferably it is less than or equal to 10 % by mass in order to suppress gelation of the preliminary polishing composition and to suppress aggregation of abrasive grains.

Alkali in the preliminary polishing composition plays a role of chemically polishing the polysilicon film 13 and contributes to an increase of the rate of polishing the polysilicon film 13 by the preliminary polishing composition. The alkali which is contained in the preliminary polishing composition may be any of ammonia; amine such as tetramethylammonium hydroxides (TMAH); ammonium salt such as ammonium carbonate; alkali metal salt such as sodium carbonate, potassium carbonate, and lithium carbonate; alkali metal hydroxide such as sodium hydroxide, potassium hydroxide, and lithium hydroxide.

When the content of alkali in the preliminary polishing composition is less than 0.05 % by mass, even when it is less than 0.1 % by mass, the polishing rate of the polysilicon film 13 by the preliminary polishing composition is not significantly improved. Therefore, it is preferable for the improvement of polishing rate of the polysilicon film 13 by the preliminary polishing composition that the content of alkali in the preliminary polishing composition is greater than or equal to 0.05 % by mass, and more preferably it is greater than or equal to 0.1 % by mass. On the other hand, when the content of alkali in the preliminary polishing composition is more than 0.4 % by mass, even when it is more than 0.3 % by mass, dishing may occur on the polished surface when the polysilicon film 13 is polished with the preliminary polishing composition since the chemical polishing effect (etching effect) is too strong. In addition, there is a possibility that abrasive grains in the preliminary polishing composition may dissolve. Therefore, it is preferable for more surely preventing occurrence of dishing and or preventing dissolution of abrasive grains that the content of alkali in the preliminary polishing composition is less than or equal to 0.4 % by mass, and more preferably it is less than or equal to 0.3 % by mass.

Water-soluble polymer in the preliminary polishing composition has an effect of suppressing occurrence of dishing on the polished surface when the polysilicon film 13 is polished with the preliminary polishing composition. This effect is attributable to the protective coating by the water-soluble polymer formed on the surface of the polysilicon film 13, which suppresses etching action of alkali from removing the inner portion of the polysilicon film 13. It is preferable that water-soluble polymer contained in the preliminary polishing composition is hydroxyethyl cellulose (HEC) or polyvinyl alcohol to strongly suppress development of dishing.

If water-soluble polymer contained in the preliminary polishing composition is polyvinyl alcohol and the average molecular weight of polyvinyl alcohol contained in the preliminary polishing composition as water-soluble polymer is less than 20,000, occurrence of dishing on the polished surface cannot be suppressed significantly when the polysilicon film 13 is polished with the preliminary polishing composition. Therefore, it is preferable that the average molecular weight of polyvinyl alcohol contained in the preliminary polishing composition as water-soluble polymer is greater than or equal to 20,000 in order to strongly suppress development of dishing. On the other hand, if the average molecular weight of polyvinyl alcohol contained in the preliminary polishing composition as water-soluble polymer is more than 50,000, the polishing rate for the polysilicon film 13 made by the preliminary polishing composition may decrease and the preliminary polishing composition may tend to foam. Therefore, it is preferable that the average molecular weight of polyvinyl alcohol contained in the preliminary polishing composition as water-soluble polymer is less than or equal to 50,000 in order to prevent decrease in the polishing rate for the polysilicon film 13 made by the preliminary polishing composition and improving defoaming properties. When the water-soluble polymer contained in the preliminary polishing composition is hydroxyethyl cellulose, the average molecular weight of hydroxyethyl cellulose contained in the preliminary polishing composition as water-soluble polymer does not matter as long as it is in the ranges of 300,000 to 1,600,000.

The content of water-soluble polymer in the preliminary polishing composition is 0.0075 to 0.05 % by mass. When the content of water-soluble polymer contained in the preliminary polishing composition is less than 0.0075 % by mass, dishing which occurs on the polished surface when the polysilicon film 13 is polished with the preliminary polishing composition can be hardly suppressed. On the other hand, when the content of water-soluble polymer in the preliminary polishing composition is more than 0.05 % by mass, polishing of the polysilicon film 13 by the preliminary polishing composition is strongly suppressed by protective coating of the water-soluble polymer formed on the surface of the polysilicon film 13 and, as a result, the polishing rate for the polysilicon film 13 made by the preliminary polishing composition is greatly decreased.

However occurrence of dishing may not be able to be suppressed significantly if the content of water-soluble polymer contained in the preliminary polishing composition is less than 0.01 % by mass even when it is greater than or equal to 0.0075 % by mass. Therefore, it is preferable for strongly suppressing occurrence of dishing that the content of water-soluble polymer contained in the preliminary polishing composition be greater than or equal to 0.01 % by mass. In addition, the polishing rate for the polysilicon film 13 made by the preliminary polishing composition may be slightly decreased if the content of water-soluble polymer contained in the preliminary polishing composition is greater than 0.03 % by mass even when it is less than or equal to 0.05 % by mass. Therefore, it is preferable for more surely preventing decrease in the polishing rate that the content of water-soluble polymer contained in the preliminary polishing composition is less than or equal to 0.03 % by mass.

### Final polishing composition

The final polishing composition is produced by mixing abrasive grains, alkali, water-soluble polymer, and water. Accordingly, the final polishing composition substantially consists of abrasive grains, alkali, water-soluble polymer, and water.

Abrasive grains in the final polishing composition play a role of mechanically polishing the polysilicon film 13 and contribute to improving the polishing rate for the polysilicon film 13 made by the final polishing composition. Abrasive grains contained in the final polishing composition may be either silica such as fumed silica and colloidal silica, or abrasive grains other than silica, but preferably they are fumed silica or colloidal silica, and particularly preferably they are colloidal silica. When the abrasive grains contained in the final polishing composition are fumed silica or colloidal silica, good polished surface is readily obtained in the case that the final polishing composition is used for polishing the polysilicon film 13. When abrasive grains contained in the final polishing composition are colloidal silica, a good polished surface is readily obtained and in addition, the polishing rate for the polysilicon film 13 made by the final polishing composition is significantly improved.

When the average particle size of abrasive grains calculated from BET specific surface area of abrasive grains contained in the final polishing composition is less than 20 nm, or even when it is less than 25 nm, the polishing rate for the polysilicon film 13 made by the final polishing composition is not significantly improved. When the polishing rate for the polysilicon film 13 made by the final polishing composition is not high enough, scratches resulting on the polished surface may increase when the polysilicon film 13 is polished with the final polishing composition. Therefore, it is preferable for the improvement of the polishing rate for the polysilicon film 13 made by the final polishing composition that the average particle size of abrasive grains contained in the final polishing composition is greater than or equal to 20 nm, and more preferably it is greater than or equal to 25 nm. On the other hand, when the average particle size of abrasive grains calculated from BET specific surface area of abrasive grains contained in the final polishing composition is greater than 100 nm, or even when it is greater than 75 nm, surface roughness of the polished surface may increases when polysilicon film 13 is polished with the final polishing composition. In addition, abrasive grains may be more likely to aggregate and thus deposit. Therefore, it is preferable that the average particle size of abrasive grains contained in the final polishing composition is less than or equal to 100 nm, and more preferably it is less than or equal to 75 nm in order to suppress increase in the roughness of the polished surface and suppress aggregation of abrasive grains.

When the content of abrasive grains in the final polishing composition is less than 0.5 % by mass, or even when it is less than 1 % by mass, the polishing rate for the polysilicon film 13 made by the final polishing composition is not significantly improved. Therefore, to increase the polishing rate for the polysilicon film 13 by the final polishing composition, it is preferable that the content of abrasive grains in the final polishing composition is greater than or equal to 0.5 % by mass, and more preferably it is greater than or equal to 1 % by mass. On the other hand, when the content of abrasive grains in the final polishing composition is more than 20 % by mass, or even when it is more than 10 % by mass, gelation of the final polishing composition and aggregation of abrasive grains may occur. Therefore, it is preferable that the content of abrasive grains in the final polishing composition is less than or equal to 20 % by mass, and more preferably it is less than or equal to 10 % by mass in order to suppress gelation of the final polishing composition and to suppress aggregation of abrasive grains.

Alkali in the final polishing composition plays a role of chemically polishing the polysilicon film 13 and contributes to improvement of the polishing rate for the polysilicon film 13 made by the final polishing composition. The alkali which is contained in the final polishing composition may be any of ammonia; amine such as tetramethylammonium hydroxides; ammonium salt such as ammonium carbonate; alkali metal salt such as sodium carbonate, potassium carbonate and lithium carbonate; alkali metal hydroxide such as sodium hydroxide, potassium hydroxide, and lithium hydroxide.

When the content of alkali in the final polishing composition is less than 0.01 % by mass, even when it is less than 0.05 % by mass, the polishing rate for the polysilicon film 13 made by the final polishing composition is not significantly improved. Therefore, it is preferable for the improvement of the polishing rate for the polysilicon film 13 made by the final polishing composition that the content of alkali in the final polishing composition is greater than or equal to 0.01 % by mass, and more preferably it is greater than or equal to 0.05 % by mass. On the other hand, when the content of alkali in the final polishing composition is more than 0.2 % by mass, even when it is more than 0.15 % by mass, dishing may occur on the polished surface when the polysilicon film 13 is polished with the final polishing composition since the chemical polishing effect (etching effect) of the alkali is too strong. In addition, abrasive grains in the final polishing composition may dissolve. Therefore, it is preferable for more surely preventing occurrence of dishing and or preventing dissolution of abrasive grains that the content of alkali in the final polishing composition is less than or equal to 0.2 % by mass, and more preferably it is less than or equal to 0.15 % by mass.

Water-soluble polymer in the final polishing composition has an effect of suppressing occurrence of dishing on the polished surface when the polysilicon film 13 is polished with the final polishing composition. This effect is attributable to the protective coating by the water-soluble polymer formed on the surface of the polysilicon film 13, which suppresses etching action of alkali from removing the inner portion of the polysilicon film 13. It is preferable that water-soluble polymer contained in the final polishing composition is hydroxyethyl cellulose or polyvinyl alcohol to strongly suppressing development of dishing.

If water-soluble polymer contained in the final polishing composition is polyvinyl alcohol and the average molecular weight of polyvinyl alcohol contained in the final polishing composition as water-soluble polymer is less than 20,000, occurrence of dishing on the polished surface cannot be suppressed significantly when the polysilicon film 13 is polished with the final polishing composition. Therefore, it is preferable that the average molecular weight of polyvinyl alcohol contained in the final polishing composition as water-soluble polymer is greater than or equal to 20,000 in order to strongly suppress development of dishing. On the other hand, if the average molecular weight of polyvinyl alcohol contained in the final polishing composition as water-soluble polymer is more than 50,000, the polishing rate for the polysilicon film 13 made by the final polishing composition may decrease and the final polishing composition may tend to foam. Therefore, it is preferable that the average molecular weight of polyvinyl alcohol contained in the final polishing composition as water-soluble polymer is less than or equal to 50,000 in order to prevent decrease in the polishing rate for polysilicon film 13 made by the final polishing composition and improving defoaming properties. When the water-soluble polymer contained in the final polishing composition is hydroxyethyl cellulose, the average molecular weight of hydroxyethyl cellulose contained in the final polishing composition as water-soluble polymer does not matter as long as it is in the ranges of 300,000 to 1,600,000.

The content of water-soluble polymer in the final polishing composition is 0.002 to 0.01 % by mass. When the content of water-soluble polymer contained in the final polishing composition is less than 0.002 % by mass, dishing which occurs on the polished surface when the polysilicon film 13 is polished with the final polishing composition can be hardly suppressed. On the other hand, when the content of water-soluble polymer in the final polishing composition is more than 0.01 % by mass, polishing of the polysilicon film 13 by the final polishing composition is strongly suppressed by protective coating of the water-soluble polymer formed on the surface of the polysilicon film 13 and, as a result, the polishing rate for polysilicon film 13 made by the final polishing composition is greatly decreased.

However, occurrence of dishing may not be able to be suppressed significantly if the content of water-soluble polymer contained in the final polishing composition is less than 0.004 % by mass even when it is greater than or equal to 0.002 % by mass. Therefore, it is preferable for strongly suppressing occurrence of dishing that the content of water-soluble polymer contained in the final polishing composition be greater than or equal to 0.004 % by mass. In addition, the polishing rate for the polysilicon film 13 made by the final polishing composition may be slightly decreased if the content of water-soluble polymer contained in the final polishing composition is greater than 0.0075 % by mass even when it is less than or equal to 0.01 % by mass. Therefore, it is preferable for more surely preventing decrease in the polishing rate that the content of water-soluble polymer contained in the final polishing composition is less than or equal to 0.0075 % by mass.

According to this embodiment, the following advantages are obtained.

The preliminary polishing composition used in preliminarily polishing to remove at least most of the outer portion of the polysilicon film 13 contains 0.0075 to 0.05 % by mass of water-soluble polymer. Therefore, according to this preliminary polishing composition, the polysilicon film 13 can be polished at a high polishing rate, and dishing on the polished surface developed when the polysilicon film 13 is polished with the preliminary polishing composition can be suppressed. Therefore, according to the present embodiment, preliminarily polishing can be preferably performed.

The final polishing composition used in finally polishing to remove at least the residue of the outer portion of the polysilicon film 13 contains 0.002 to 0.01 % by mass of water-soluble polymer. Therefore, according to this final polishing composition, polysilicon film 13 can be polished at a high polishing rate, and dishing on the polished surface developed when polysilicon film 13 is polished with the final polishing composition can be suppressed. Therefore, according to the present embodiment, final polishing can be preferably performed.

The above embodiment may be changed as follows.

Two or more kinds of abrasive grains may be contained in the preliminary polishing composition of the above embodiment.

Two or more kinds of alkalis may be contained in the preliminary polishing composition of the above embodiment.

Two or more kinds of water-soluble polymers may be contained in the preliminary polishing composition of the above embodiment.

Mildewproofing agents, anticorrosives, defoaming agents, chelating agents, etc. may be added in the preliminary polishing composition of the above embodiment if necessary.

The preliminary polishing composition of the above embodiment may be prepared by mixing a first agent and a second agent which contain at least one ingredient of abrasive grains, alkali, and water-soluble polymer along with water respectively. The preliminary polishing composition of the above embodiment may be prepared by, for example, mixing the first agent consisting of abrasive grains and water and the second agent consisting of alkali, water-soluble polymer, and water, or it may be prepared by mixing the first agent consisting of abrasive grains, alkali, water-soluble polymer, and water and the second agent consisting of water. The first agent and the second agent may be mixed by supplying the first agent and the second agent independently and simultaneously onto the polysilicon film 13 to be polished. More specifically, the first agent and the second agent may be mixed in a supply line of polishing agents in a polishing device, or they may be mixed on a polishing machine platen of a polishing device.

The preliminary polishing composition of the above embodiment may be prepared by mixing a final polishing composition and an adjuvant which contains at least one ingredient of abrasive grains, alkali, water-soluble polymer, and water. The final polishing composition and the adjuvant may be mixed by supplying the final polishing composition and the adjuvant independently and simultaneously onto the polysilicon film 13 to be polished. More specifically, the final polishing composition and the adjuvant may be mixed in a supply line of polishing agents in a polishing device, or they may be mixed on a polishing machine platen of a polishing device.

Two or more kinds of abrasive grains may be contained in the final polishing composition of the above embodiment.

Two or more kinds of alkalis may be contained in the final polishing composition of the above embodiment.

Two or more kinds of water-soluble polymers may be contained in the final polishing composition of the above embodiment.

Mildewproofing agents, anticorrosives, defoaming agents, chelating agents, etc. may be added in the final polishing composition of the above embodiment if necessary.

The final polishing composition of the above embodiment may be prepared by mixing a first agent and a second agent which contain at least one ingredient of abrasive grains, alkali, and water-soluble polymer along with water respectively. The final polishing composition of the above embodiment may be prepared by, for example, mixing the first agent consisting of abrasive grains and water and the second agent consisting of alkali, water-soluble polymer, and water, or it may be prepared by mixing the first agent consisting of abrasive grains, alkali, water-soluble polymer, and water, and the second agent consisting of water. The first agent and the second agent may be mixed by supplying the first agent and the second agent independently and simultaneously onto the polysilicon film 13 to be polished. More specifically, the first agent and the second agent may be mixed in a supply line of polishing agents in a polishing device, or they may be mixed on a polishing machine platen of a polishing device.

The final polishing composition of the above embodiment may be prepared by mixing a preliminary polishing composition and an adjuvant which contains at least one ingredient of abrasive grains, alkali, water-soluble polymer, and water. The preliminary polishing composition and the adjuvant may be mixed by supplying the preliminary polishing composition and the adjuvant independently and simultaneously onto the polysilicon film 13 to be polished. More specifically, the preliminary polishing composition and the adjuvant may be mixed in a supply line of polishing agents in a polishing device, or they may be mixed on a polishing machine platen of a polishing device.

Examples and Comparative Examples of the present invention are described next.

### Examples 1-8 and Comparative Examples 1-8

Colloidal silica, tetramethylammonium hydroxide, hydroxyethyl cellulose, and water were appropriately mixed and preliminary polishing compositions of Examples 1-8 and Comparative Examples 1-8 were prepared. Contents of colloidal silica, tetramethylammonium hydroxide, and hydroxyethyl cellulose in the preliminary polishing compositions of Examples 1-8 and Comparative Examples 1-8 are as shown in Table 1.

A wafer with polysilicon film was polished under polishing conditions shown in Table 2 using each of the preliminary polishing compositions of Examples 1-8 and Comparative Examples 1-8 till a predetermined endpoint based on the change of electrical current value of the motor which drove polishing machine platen was detected. Amount of dishing (depth of recessed part by dishing) measured in a line and space part of 100 µm width of a wafer after polishing with profiler "HRP340" of KLA-Tencor Corporation which is a contact-type surface measuring apparatus is shown in "Amount of dishing" column in Table 1.

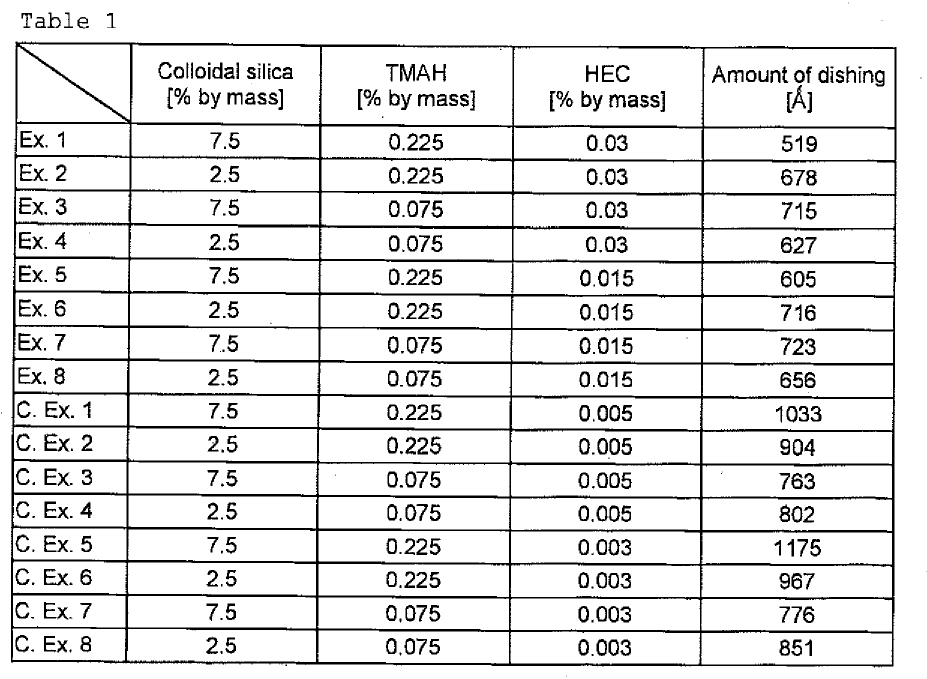

**Table 2**

| |
|---|
| Polishing device: CMP device "EPO-113D" of Ebara Corporation |
| Polishing load: 27,6 kPa (4.0 psi) |
| Polishing linear velocity: 60 m/min |
| Supply rate of polishing composition: 200 mL/min |

As shown in Table 1, it was revealed that the amount of dishing was reduced more in the preliminary polishing compositions of Examples 1-8 in which content of hydroxyethyl cellulose was greater than or equal to 0.015 % by mass, as compared with the preliminary polishing compositions of Comparative Examples 1-8 in which the content of hydroxyethyl cellulose was less than or equal to 0.005 % by mass.

### Examples 9-16 and Comparative Examples 9-16

Colloidal silica, tetramethylammonium hydroxide, hydroxyethyl cellulose, and water were appropriately mixed and final polishing compositions of Examples 9-16 and Comparative Examples 9-16 were prepared. Contents of colloidal silica, tetramethylammonium hydroxide, and hydroxyethyl cellulose in the final polishing compositions of Examples 9-16 and Comparative Examples 9-16 are as shown in Table 3.

A wafer with polysilicon film was preliminarily polished under polishing conditions shown in Table 2 using the preliminary polishing composition of Example 1 till a predetermined endpoint based on the change of electrical current value of the motor which drove polishing machine platen was detected. Then, the wafer after preliminarily polishing was subjected to finally polishing under polishing conditions shown in Table 2 using each of the final polishing compositions of Examples 9-16 and Comparative Examples 9-16 for 60% of time period required in the precedent polishing. Amount of dishing measured with profiler "HRP340" in a line and space part of 100 µm width of a wafer after finally polishing was subtracted with the amount of dishing measured with profiler "HRP340" in a line and space part of 100 µm width of a wafer after preliminarily polishing and the resulting values are shown in "Increment of dishing" column in Table 3.

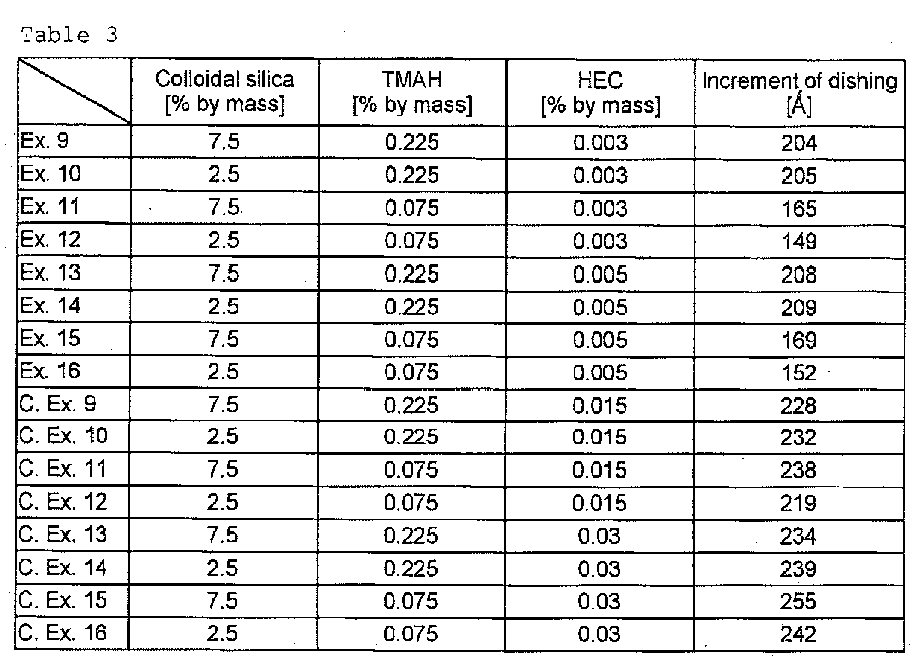

As shown in Table 3, it was revealed that the increment of dishing was reduced more in the final polishing compositions of Examples 9-16 in which the content of hydroxyethyl cellulose was less than or equal to 0.005 % by mass, as compared with the final polishing compositions of Comparative Examples 9-16 in which the content of hydroxyethyl cellulose.was greater than or equal to 0.015 % by mass. It was also revealed that the increment of dishing was reduced more in the final polishing compositions of Examples 11, 12, 15 and 16 in which the content of tetramethylammonium hydroxide was 0.075 % by mass, as compared with the final polishing compositions of Examples 9, 10, 13 and 14 in which content of tetramethylammonium hydroxide was 0.225 % by mass.

### Examples 17-24 and Comparative Examples 17-24

Colloidal silica, tetramethylammonium hydroxide, hydroxyethyl cellulose, and water were appropriately mixed and final polishing compositions of Examples 17-24 and Comparative Examples 17-24 were prepared. Contents of colloidal silica, tetramethylammonium hydroxide, and hydroxyethyl cellulose in each of the final polishing compositions of Examples 17-24 and Comparative Examples 17-24 are as shown in Table 4.

A wafer with polysilicon film was polished under polishing conditions shown in Table 2 using the preliminarily polishing composition of Example 5 till a predetermined endpoint based on the change of electrical current value of the motor which drove polishing machine platen was detected. Then, the wafer after preliminarily polishing was subjected to finally polishing under polishing conditions shown in Table 2 using each of the final polishing compositions of Examples 17-24 and Comparative Examples 17-24 for 60% of time period required in the precedent polishing. The amount of dishing after preliminarily polishing was subtracted from the amount of dishing after finally polishing and the resulting values are shown in "Increment of dishing" column in Table 4, as in Examples 9-16 and Comparative Examples 9-16.

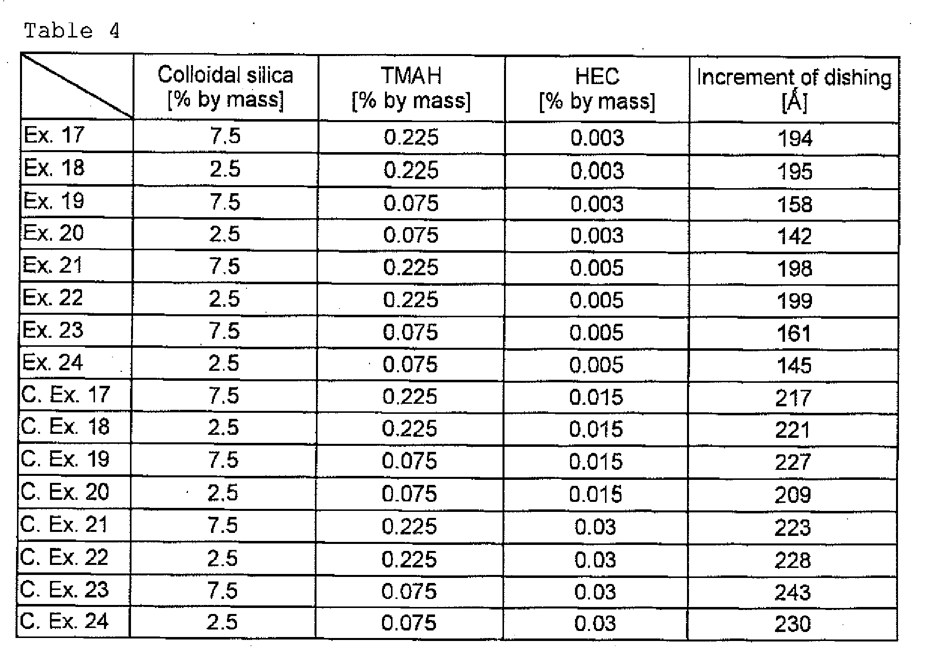

As shown in Table 4, it was revealed that the increment of dishing was reduced more in the final polishing compositions of Examples 17-24 in which the content of hydroxyethyl cellulose was less than or equal to 0.005 % by mass, as compared with the final polishing compositions of Comparative Examples 17-24 in which the content of hydroxyethyl cellulose was greater than or equal to 0.015 % by mass. It was also revealed that the increment of dishing was reduced more in the final polishing compositions of Examples 19, 20, 23 and 24 in which the content of tetramethylammonium hydroxide was 0.075 % by mass, as compared with the final polishing compositions of Examples 17, 18, 21 and 22 in which the content of tetramethylammonium hydroxide was 0.225 % by mass.

## Claims

1. A polishing method for polishing a polysilicon film provided on a silicon substrate having an isolation region, the method **characterized by**:
preliminarily polishing the polysilicon film using a preliminary polishing composition containing abrasive grains, an alkali, a water-soluble polymer, and water till a part of the top surface of the isolation region is exposed; and
finally polishing the preliminarily polished polysilicon film using a final polishing composition containing abrasive grains, an alkali, a water-soluble polymer, and water till the whole top surface of the isolation region is exposed,
wherein the content of the water-soluble polymer in the preliminary polishing composition is 0.0075-0.05 % by mass, and the content of the water-soluble polymer in the final polishing composition is 0.002-0.01 % by mass.

2. The method according to claim 1 further **characterized by**:
preparing the preliminary polishing composition by mixing a first agent and a second agent which contain at least one ingredient of the abrasive grains, the alkali, and the water-soluble polymer along with water, respectively, prior to the preliminarily polishing of the polysilicon film; and
preparing the final polishing composition by mixing the first agent and the second agent which contain at least one ingredient of the abrasive grains, the alkali, and the water-soluble polymer along with water, respectively, prior to the finally polishing of the polysilicon film.

3. The method according to claim 2, **characterized in that** the mixing of the first agent and the second agent is performed by supplying the first agent and the second agent onto the polysilicon film to be polished independently and simultaneously.

4. The method according to claim 1, further **characterized by** preparing the preliminary polishing composition by mixing the final polishing composition and an adjuvant which contains at least one ingredient of the abrasive grains, the alkali, the water-soluble polymer, and water, prior to the preliminary polishing of the polysilicon film.

5. The method according to claim 4, **characterized in that** the mixing of the final polishing composition and the adjuvant is performed by supplying the final polishing composition and the adjuvant onto the polysilicon film to be polished independently and simultaneously.

6. The method according to claim 1, further **characterized by** preparing the final polishing composition by mixing the preliminary polishing composition and an adjuvant which contains at least one ingredient of the abrasive grains, the alkali, the water-soluble polymer, and water, prior to the finally polishing of the polysilicon film.

7. The method according to claim 6, **characterized in that** the mixing of the preliminary polishing composition and the adjuvant is performed by supplying the preliminary polishing composition and the adjuvant onto the polysilicon film to be polished independently and simultaneously.

8. A polishing composition used for polishing a polysilicon film provided on a silicon substrate having an isolation region, **characterized by** containing abrasive grains, an alkali, a water-soluble polymer, and water, wherein the content of the water-soluble polymer in the polishing composition is 0.0075-0.05 % by mass.

9. A polishing composition used for polishing a polysilicon film provided on a silicon substrate having an isolation region, **characterized by** containing abrasive grains, an alkali, a water-soluble polymer, and water, wherein the content of the water-soluble polymer in the polishing composition is 0.002-0.01 % by mass.

10. A kit for use in polishing a polysilicon film provided on a silicon substrate having an isolation region, the kit **characterized by**:
a preliminary polishing composition used in preliminarily polishing the polysilicon film till a part of the top surface of the isolation region is exposed; and
a final polishing composition used in finally polishing the preliminarily polished polysilicon film till the whole top surface of the isolation region is exposed,
wherein the preliminary polishing composition contains abrasive grains, an alkali, a water-soluble polymer, and water, and the content of the water-soluble polymer in the preliminary polishing composition is 0.0075-0.05 % by mass, and
wherein the final polishing composition contains abrasive grains, an alkali, a water-soluble polymer, and water, and the content of the water-soluble polymer of the final polishing composition is 0.002-0.01 % by mass.

11. A kit for use in polishing a polysilicon film provided on a silicon substrate having an isolation region, the kit **characterized by**:
a preliminary polishing composition containing abrasive grains, an alkali, a water-soluble polymer, and water, wherein the content of the water-soluble polymer in the preliminary polishing composition is 0.0075-0.05 % % by mass; and
an adjuvant containing at least one ingredient of abrasive grains, an alkali, a water-soluble polymer, and water, the adjuvant being mixed with the preliminary polishing composition to prepare a final polishing composition.

12. A kit for use in polishing a polysilicon film provided on a silicon substrate having an isolation region, the kit **characterized by**:
a final polishing composition containing abrasive grains, an alkali, a water-soluble polymer, and water, wherein the content of the water-soluble polymer in the final polishing composition is 0.002-0.01 % by mass; and
an adjuvant containing at least one ingredient of abrasive grains, an alkali, a water-soluble polymer, and water, the adjuvant being mixed with the final polishing composition to prepare a preliminary polishing composition.
